# FASCICULE DE BREVET EUROPEEN

(11) **EP 2 745 661 B1**
(45) Date de publication et mention de la délivrance du brevet: **04.07.2018**
(21) Numéro de dépôt: 12750456.1
(22) Date de dépôt: 31.07.2012
(51) Int. Cl.: H05K 7/14, H05K 1/02, H02K 11/00, H05K 5/00

(54) **DISPOSITIF DE CONNEXION ELECTRIQUE, ENSEMBLE COMPRENANT UN TEL DISPOSITIF ET UNE CARTE ELECTRONIQUE ET PROCEDE DE CONNEXION ELECTRIQUE D'UNE CARTE ELECTRONIQUE**
ELEKTRISCHE VERBINDUNGSVORRICHTUNG, ANORDNUNG MIT EINER SOLCHEN VORRICHTUNG UND ELEKTRONIKPLATINE SOWIE VERFAHREN ZUM ELEKTRISCHEN ANSCHLUSS EINER ELEKTRONIKPLATINE
ELECTRICAL CONNECTION DEVICE, ASSEMBLY INCLUDING SUCH A DEVICE AND AN ELECTRONIC BOARD, AND METHOD FOR ELECTRICALLY CONNECTING AN ELECTRONIC BOARD

(30) Priorité: 08.08.2011 FR 1157236
(43) Date de publication de la demande: 25.06.2014
(73) Titulaire: Valeo Systèmes de Contrôle Moteur, 95800 Cergy (FR)
(72) Inventeur: SMAL, Pierre, F-78500 Sartrouville (FR); SANVITO, Guillaume, F-78990 Elancourt (FR)
(74) Mandataire: Argyma
(86) Numéro de dépôt international: PCT/FR2012/051804
(87) Numéro de publication internationale: WO 2013/021119

(56) Documents cités:
- EP-A1- 0 911 949
- EP-A1- 1 117 155
- DE-A1-102009 043 322
- GB-A- 2 259 613
- US-A- 3 315 217
- US-A- 5 575 663
- US-A1- 2009 124 111
- US-A1- 2010 020 516

## Description

L'invention concerne un dispositif de connexion électrique d'une carte électronique. En particulier, l'invention concerne un dispositif de connexion électrique d'une carte électronique montée dans un carter de machine électrique.

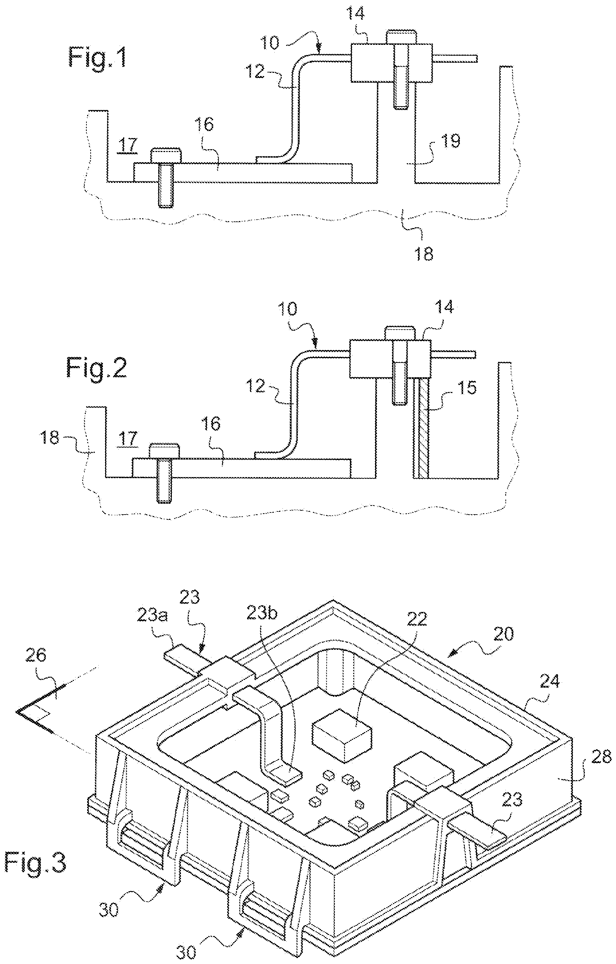

Il est connu d'utiliser un dispositif de connexion électrique pour connecter une carte électronique. La figure 1 présente un exemple d'un tel dispositif de connexion électrique 10. Typiquement, le dispositif de connexion 10 comprend des connecteurs électriques 12 en forme de languette, maintenus ensemble par une matière 14 isolante électriquement. Un tel dispositif 10 est connu sous le terme « busbar ».

Les connecteurs 12 assurent la connexion électrique d'une carte électronique 16. Typiquement, la carte électronique 16 est logée dans un évidement 17 d'un carter 18 d'une machine électrique (non représentée) afin de fournir des signaux de puissance ou de commande à la machine électrique.

Lors de la connexion électrique de la carte électronique 16, le dispositif de connexion électrique 10 est positionné et fixé sur le carter 18 par exemple sur une portion 19 du carter 18. Les extrémités des connecteurs électriques 12 viennent en contact avec la surface de la carte électronique 16 pour mettre en contact électrique les composants de la carte 16. La mise en contact électrique des connecteurs électriques 12 avec des bornes des composants peut être réalisée par exemple par une soudure ou par une brasure par refusion électrique.

Cependant, la qualité de la connexion électrique dépend fortement de la contrainte mécanique ou effort entre les connecteurs 12 et la carte 16 lors de l'opération de connexion électrique. Pour assurer une durée de vie de la connexion électrique, les connecteurs 12 doivent exercer une contrainte mécanique sur la carte 16. Il est donc recherché d'obtenir une contrainte mécanique entre les connecteurs 12 du dispositif de connexion électrique 10 et la carte 16.

A cet effet, le dispositif de connexion 10 est vissé sur le carter 18 de sorte que ses connecteurs 12 exercent un effort sur la carte électronique 16, par exemple sur les bornes des composants. Puis l'ensemble, comprenant le carter 18, la carte électronique 16 et le dispositif de connexion 10, est passé typiquement dans un poste de soudage afin de souder les connecteurs 12 sur la carte électronique 16. Cependant, si la soudure se révèle défaillante, il est difficile de récupérer les éléments de l'ensemble tels que le carter 18 pour les réutiliser.

Une autre solution consiste à d'abord souder le dispositif de connexion électrique 10 et la carte 16 avec un effort permettant d'assurer une durée de vie de la soudure. Puis, l'ensemble constitué de la carte 16 et du dispositif de connexion électrique 10 est monté dans l'évidement 17 du carter 18. Cependant, des contraintes d'arrachement entre les connecteurs 12 et la carte 16 peuvent apparaître après le montage de la carte 16 et du dispositif 10, en particulier lors du vissage du dispositif 10 dans le carter 18. Ces contraintes d'arrachement fragilisent la soudure et réduisent donc sa durée de vie. Il est connu de positionner un muret 15 sous le dispositif de connexion 10 tel que présenté en figure 2. Ainsi, lors du vissage du dispositif de connexion 10 sur le carter 18, le connecteur 12 bascule vers l'avant pour venir en appui sur la carte électronique 16. Cependant, entre l'opération de soudage et le montage dans le carter 18, la carte 16 et le dispositif 10 doivent être manipulés avec précaution pour éviter que l'un ne bouge par rapport à l'autre, ce qui entraînerait une fragilisation de la soudure. Le document US 3,315,217 décrit un dispositif de connexion électrique selon le préambule de la revendication 1. Il est donc recherché un moyen simple et sûr assurant une contrainte mécanique entre des connecteurs électriques et une carte électronique.

A cet effet, il est proposé un dispositif de connexion électrique d'une carte selon la revendication 1. La portion du conducteur électrique maintenue par le corps peut être solidarisée à ce dernier par exemple par bouterollage, encliquetage, par emprisonnement dans la matière du corps, ce dernier étant par exemple surmoulé, ou par montage en force dans un logement du corps.

Selon un mode de réalisation, l'organe d'assemblage comprend une première portion sensiblement plane naissant au niveau d'une extrémité distale de l'excroissance et s'étendant vers l'extérieur du dispositif de connexion.

Selon un mode de réalisation, ladite première portion comprend un trou traversant.

Selon un mode de réalisation, l'organe d'assemblage comprend une deuxième portion sensiblement plane transversale à la première portion, la deuxième portion comprenant un trou.

Selon un mode de réalisation, le trou est traversant.

Selon un mode de réalisation, le corps s'étend au moins suivant un plan et maintient le conducteur électrique au niveau dudit plan, et ladite excroissance s'étend depuis ledit corps suivant une direction transversale audit plan.

Selon un mode de réalisation, le corps a une forme sensiblement rectangulaire dans ledit plan.

Selon un mode de réalisation, l'excroissance s'étend depuis une périphérie du corps.

Selon un mode de réalisation, le corps et l'excroissance sont d'un seul tenant.

L'invention concerne également un ensemble comprenant une première carte électronique et un dispositif de connexion électrique selon l'invention dans lequel le corps du dispositif de connexion a une première face venant en vis-à-vis de la première carte électronique, et l'organe d'assemblage solidarise ensemble la première carte électronique et le dispositif de connexion.

Selon un mode de réalisation, l'organe d'assemblage solidarise le dispositif de connexion et la première carte au niveau d'une périphérie de la première carte.

Selon un mode de réalisation, la première carte électronique comprend un ergot venant en prise dans le trou de l'organe d'assemblage, notamment le trou de la deuxième portion de cet organe.

Selon un mode de réalisation, ledit ergot est situé sur un bord périphérique de la première carte électronique.

Selon un mode de réalisation, l'ensemble comprend en outre une deuxième carte électronique montée en vis-à-vis d'une deuxième face du corps, ladite deuxième face étant opposée à la première face.

L'invention concerne également un procédé de connexion électrique d'une carte électronique comprenant des étapes consistant à :
- assembler le dispositif selon l'invention avec la carte électronique par l'intermédiaire de l'organe d'assemblage,
- connecter le conducteur électrique dudit dispositif de connexion à la carte électronique.

Selon un mode de réalisation, le conducteur électrique est connecté par brasure.

Le dispositif de connexion électrique selon l'invention permet de connecter une carte électronique. Le dispositif comprend au moins un conducteur électrique pour conduire un courant vers et/ou depuis ladite carte électronique. Le dispositif comprend en outre un corps maintenant le conducteur électrique au niveau d'une portion du conducteur. Grâce au corps, le conducteur électrique peut être manipulé pour venir en position avec la carte suivant une direction de façon à assurer une connexion électrique de la carte. Au moins une excroissance s'étend depuis le corps. Cette excroissance comprend au moins un organe d'assemblage du dispositif de connexion avec la carte électronique. L'excroissance et l'organe d'assemblage permettent de maintenir en position le conducteur électrique par rapport à la carte électronique. Ainsi, le conducteur et la carte électronique ne subissent pas de déplacement l'un par rapport à l'autre. Le conducteur peut donc être connecté à la carte de façon sûre, et l'ensemble constitué du dispositif de connexion et de la carte peut être manipulé sans entraîner de fragilisation de la connexion du conducteur et de la carte.

Selon l'invention, ladite excroissance s'étend depuis ledit corps suivant une direction transversale audit plan.

Selon un mode de réalisation des dispositifs selon l'invention, le corps a une forme de paroi qui s'étend dans un plan. En particulier, le corps comprend au moins une ouverture configurée pour permettre d'accéder à l'extrémité du conducteur qui est en contact avec la carte lorsque le dispositif est positionné sur celle-ci.

Selon un mode de réalisation, l'ensemble selon l'invention est en outre configuré pour être plaqué sur une surface, ensemble dans lequel le dispositif selon l'invention comprend un conducteur configuré pour permettre une reprise de masse entre la carte électronique et ladite surface.

L'invention pourra être mieux comprise à la lecture de la description qui va suivre d'exemples non limitatifs de mise en oeuvre de celle-ci et à l'examen des dessins annexés, sur lesquels :
- la figure 1 représente un dispositif de connexion électrique selon l'art antérieur connecté à une carte électronique ;
- la figure 2 représente un autre dispositif de connexion électrique selon l'art antérieur connecté à une carte électronique ;
- la figure 3 représente une vue en perspective d'un exemple de dispositif de connexion électrique selon l'invention connecté à une carte électronique ;
- la figure 4 représente une vue en coupe de l'exemple de dispositif présenté en figure 3 ;
- la figure 5 représente une vue en coupe d'un exemple de dispositif selon l'invention ;
- la figure 6 représente une vue en coupe d'un autre exemple de dispositif selon l'invention ;
- la figure 7 représente une vue en coupe d'encore un autre exemple de dispositif selon l'invention ;
- la figure 8 représente une vue en perspective d'un dernier exemple du dispositif selon l'invention ;
- la figure 9 représente une vue de dessus de l'exemple de la figure 8.

Il faut noter que les figures exposent l'invention de manière détaillée pour mettre en oeuvre l'invention. Ces figures peuvent bien entendu servir à mieux définir l'invention le cas échéant.

On va décrire un dispositif 20 selon un exemple de mise en oeuvre selon l'invention en faisant référence à la figure 3, dans laquelle le dispositif 20 est connecté à une carte électronique 22.

Le dispositif 20 comprend au moins un conducteur électrique 23 maintenu par un corps 24. Le corps 24 permet de manipuler le conducteur électrique 23 afin de l'amener en contact avec la carte électronique 22.

Par exemple, le corps 24 s'étend au moins suivant un plan 26. En particulier, le corps 24 a une forme sensiblement rectangulaire dans ce plan 26. Le corps 24 peut alors présenter la forme d'un cadre ou avoir une surface pleine. En particulier, le corps 24 a une forme destinée à venir en correspondance avec une périphérie extérieure de la carte électronique 22.

Le conducteur électrique 23 permet notamment de relier un composant de la carte 22 à un élément extérieur à la carte 22 tel qu'une source électrique haute tension, un moteur électrique ou tout autre composant électronique. Par exemple, le conducteur 23 délivre à la carte 22 un courant provenant d'une source électrique. En particulier, le courant est compris entre 4 A et 400 A. Dans un autre exemple le conducteur 23 transmet un courant provenant de la carte 22 vers un moteur électrique.

Le conducteur électrique 23 est notamment configuré pour pouvoir être déformé. Par exemple, le conducteur électrique est une lame ressort 23. Ainsi, le conducteur électrique 23 peut subir une déformation de façon à permettre d'amener la carte électronique 22 et l'assembler avec le dispositif de connexion 20.

Par exemple, le conducteur 23 comprend deux extrémités 23a, 23b. Une première extrémité 23a du conducteur 23 est libre de la matière du corps 24 pour être mise en contact avec l'élément extérieur à la carte 22. Une deuxième extrémité 23b est également libre de la matière du corps 24 pour être mise en contact avec la carte électronique 22.

Dans l'exemple décrit, le conducteur 23 est maintenu par le corps 24 au niveau d'une portion comprise entre la première extrémité 23a et la seconde extrémité 23b par tout moyen connu. En particulier, la matière du corps 24 enveloppe cette portion du conducteur 23. Autrement dit, la matière du corps 24 vient en prise avec la portion du conducteur 23. Le corps 24 peut être surmoulé autour de la portion. Alternativement, le conducteur 23 peut être introduit dans une ouverture ajustée du corps 24 pour être maintenu au niveau de cette portion. Dans un exemple particulier, le conducteur 23 est maintenu par le corps 24 par bouterollage ou par encliquetage.

Dans un exemple, le conducteur 23 s'étend au moins en partie dans le plan 26 et est maintenu par le corps 24 au niveau de ce plan 26.

En particulier, entre la portion comprise dans le plan 26 et la deuxième extrémité 23b, le conducteur 23 présente une déformation dans une direction transversale, notamment perpendiculaire, au plan 26. Ainsi, la deuxième extrémité 23b du conducteur 23 vient en contact avec la carte 22 lorsque la carte 22 est approchée du dispositif de connexion 20 suivant une direction transversale, notamment perpendiculaire, au plan 26.

Le conducteur 23 est en un matériau présentant une conductivité électrique pour un fonctionnement de composants électroniques. Par exemple, le conducteur 23 est en un métal tel que du cuivre ou en un alliage tel qu'un alliage d'aluminium et de cuivre.

Le dispositif 20 peut comprendre un ou plusieurs conducteurs 23 tel que décrit précédemment. Dans un mode de réalisation, le dispositif 20 comprend plusieurs conducteurs 23. Le corps 24 permet alors de manipuler ensemble les conducteurs 23. Ainsi, les conducteurs 23 peuvent être amenés en même temps sur la carte 22 pour y être connectés. La connexion de la carte 22 est donc simplifiée.

En particulier, les conducteurs 23 s'étendent au moins en partie dans le plan 26 et sont maintenus ensemble dans ce plan 26. Entre leur portion comprise dans le plan 26 et leur deuxième extrémité 23b, les conducteurs 23 présentent une déformation suivant une direction transversale, notamment perpendiculaire, au plan 26, en s'étendant à partir d'une même face du plan 26. Ainsi, les deuxièmes extrémités 23b des conducteurs 23 viennent en contact avec la carte 22 lorsque la carte 22 est approchée du dispositif de connexion 20 suivant une direction transversale, notamment perpendiculaire, au plan 26 en vis-à-vis de cette face.

Le dispositif 20 comprend au moins une excroissance 28 qui s'étend depuis le corps 24. L'excroissance 28 comprend au moins un organe d'assemblage 30 avec la carte électronique 22.

L'excroissance 28 et l'organe d'assemblage 30 permettent de maintenir en position le conducteur électrique 23 par rapport à la carte électronique 22. En particulier, la deuxième extrémité 23b du conducteur 23 et la carte électronique 22 ne subissent pas de déplacement l'une par rapport à l'autre. Le conducteur 23 peut donc être connecté à la carte 22 de façon sûre, et l'ensemble constitué du dispositif de connexion 10 et de la carte 22 peut être manipulé sans entraîner de fragilisation de la connexion du conducteur 23 et de la carte 22.

Dans un mode de réalisation, l'excroissance 28 s'étend par exemple depuis une périphérie du corps 24. En particulier, la périphérie est comprise dans la portion du corps 24 s'étendant dans le plan 26. L'excroissance 28 s'étend par exemple suivant une direction transversale, notamment perpendiculaire, au plan 26. L'excroissance 28 s'étend à partir de la même face du plan 26 que le conducteur électrique 23. Dans un exemple particulier, l'excroissance 28 est une paroi continue s'étendant depuis toute la périphérie du corps 24, notamment sur le pourtour de ce dernier.

Le corps 24 et l'excroissance 28 sont par exemple d'un seul tenant. En particulier, l'excroissance 28 est venue de matière avec le corps 24. Le corps 24 et l'excroissance 28 sont de préférence en un matériau isolant électriquement tel qu'un plastique. Les plastiques possèdent en effet les caractéristiques isolantes nécessaires permettant d'isoler électriquement le conducteur électrique 23 tout en étant assez rigide pour permettre à l'excroissance 28 de maintenir la position du conducteur 23 par rapport à la carte électronique 22.

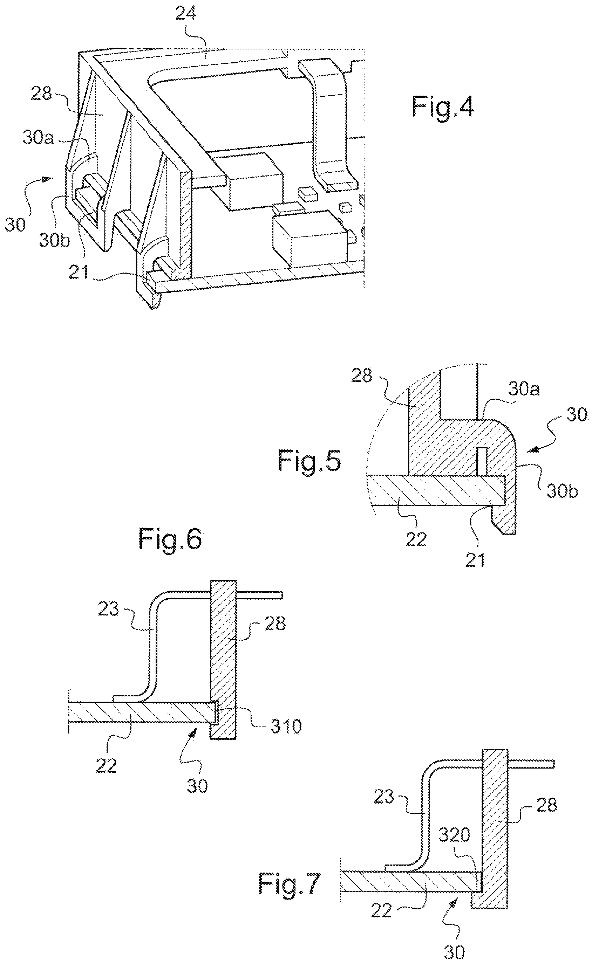

L'organe d'assemblage 30 solidarise le dispositif de connexion 20 avec la carte électronique 22. L'organe d'assemblage 30 sera mieux décrit en faisant référence aux figures 4 et 5.

L'organe d'assemblage 30 est par exemple positionné à une extrémité distale de l'excroissance 28. L'organe d'assemblage 30 peut comprendre une première portion 30a sensiblement plane qui naît au niveau de l'extrémité distale de l'excroissance 28 pour s'étendre vers l'extérieur du dispositif de connexion 20. En particulier, la première portion 30a s'étend dans une dimension sensiblement orthogonale par rapport à l'extrémité distale de l'excroissance 28.

Par exemple, la première portion 30a comprend un trou traversant. Un organe de solidarisation, tel qu'une vis, vient dans le trou traversant et dans un trou correspondant de la carte 22 afin de solidariser le dispositif de connexion 20 avec la carte 22.

L'organe d'assemblage 30 peut comprendre en outre une deuxième portion 30b sensiblement plane transversale à la première portion 30a. La deuxième portion 30b comprend un trou dans lequel un élément de la carte 22 peut venir par encliquetage par exemple. Ainsi, l'organe d'assemblage 30 vient solidariser le dispositif de connexion 10 à la carte électronique 22. Le trou peut être traversant tel qu'illustré en figure 4 ou non traversant tel qu'illustré en figure 5.

Dans un mode de réalisation illustré en figure 6, l'organe d'assemblage 30 consiste en une rainure 310 dans l'extrémité distale de l'excroissance 28. Un bord périphérique de la carte électronique 22 est destiné à venir en correspondance avec la rainure 310.

Dans un autre mode de réalisation illustré en figure 7, l'organe d'assemblage 30 consiste en une portion 320 sensiblement plane qui naît au niveau de l'extrémité distale de l'excroissance 28 pour s'étendre vers l'intérieur du dispositif de connexion 20. La carte électronique 22 est destinée à venir se poser sur cette portion 320. En particulier, la carte électronique 22 est maintenue par la pression exercée par le conducteur électrique 23.

Dans les deux modes de réalisation précédents, le corps 24 et/ou l'excroissance 28 sont de préférence en un plastique suffisamment déformable pour permettre d'introduire la carte 22 dans la rainure 310 ou sur la portion 320 et à la fois suffisamment rigide pour maintenir le conducteur électrique 23 en position par rapport à la carte 22.

Dans un mode de réalisation, la deuxième extrémité 23b des conducteurs électriques 23 est située à une distance du plan 26 supérieure à la distance de l'extrémité distale de l'excroissance 28. Ainsi, lorsque le dispositif de connexion 10 vient sur la carte électronique 22, les connecteurs 23 exercent une contrainte sur la surface de la carte. Ainsi, les connexions des conducteurs 23 sur la carte électronique 22 sont renforcées, en particulier lorsque les connexions sont des soudures ou des brasures.

L'invention concerne également un ensemble comprenant le dispositif de connexion 10 selon l'invention et une première carte électronique. La première carte électronique correspond par exemple à la carte électronique 22 décrite précédemment.

Dans l'ensemble selon l'invention, une première face du corps 24 vient en vis-à-vis de la première carte 22.

L'organe d'assemblage 30 solidarise ensemble la première carte électronique 22 et le dispositif de connexion 20. Ainsi, le conducteur électrique 23 est positionné sur la première carte 22 pour lui être connecté. Le connecteur peut être connectés à la carte électronique avant le montage de l'ensemble dans un évidement d'un carter par exemple. On évite donc des difficultés de connexion liées à l'environnement de l'évidement, par exemple liées à l'encombrement du à d'autres composants du carter. La première carte 22 et le dispositif de connexion 20 peuvent être manipulés ensemble sans fragiliser la connexion du conducteur 23 avec la carte 22. En particulier, le conducteur 23 exerce une contrainte sur la première carte 22. Ainsi, la connexion du conducteur 23 avec la première carte 22 a une durée de vie améliorée. Par exemple, la connexion est une soudure ou une brasure par refusion électrique

Dans un mode de réalisation, le dispositif de connexion 20 et la carte 22 sont solidaires au niveau d'une périphérie de la carte 22. Ainsi, la partie interne de la carte 22 est réservée aux composants électriques, le routage des composants en est simplifié.

Dans un autre mode de réalisation, le dispositif de connexion 20 est solidarisé sur une partie de la carte électronique 22. La première face du dispositif de connexion 20 vient en vis-à-vis d'une première portion de la carte électronique 22 afin de connecter la première portion avec le ou les conducteurs électriques 23. Une seconde portion de la carte 22 reste libre du ou des conducteurs électriques 23.

Dans encore un autre mode de réalisation, la première face du dispositif de connexion 20 comprend une première portion qui vient en vis-à-vis de la totalité de la carte 22 et une seconde portion qui reste libre de la carte électronique 22. La seconde portion du dispositif de connexion peut loger des composants électroniques par exemple.

Dans un exemple dans lequel l'organe d'assemblage comprend une première portion, et notamment une seconde portion, avec un trou, la carte comprend un ergot 21 venant en prise avec le trou. Ainsi, le dispositif 10 et la carte 22 sont solidarisés sans le recours à un organe de connexion tel qu'une vis. En particulier, l'ergot 21 est situé sur un bord périphérique de la carte 22.

L'ensemble peut comprendre en outre une deuxième carte électronique (non représentée). La deuxième carte électronique est montée en vis-à-vis d'une deuxième face du corps 24. La deuxième face est opposée à la première face. Dans l'exemple présenté en figure 1, la deuxième carte électronique vient au dessus du dispositif de connexion 20 et recouvre la partie ouverte du corps 24 en forme de rectangle.

La première ou la deuxième cartes sont par exemple, des cartes à substrat métallique isolé ou carte SMI permettant un refroidissement de leurs composants par l'intermédiaire de la carte.

L'invention concerne également un procédé de connexion électrique d'une carte électronique, telle que la carte électronique 22. Le procédé comprend l'assemblage du dispositif de connexion 10 selon l'invention avec la carte électronique 22 par l'intermédiaire de l'organe d'assemblage 30. Ensuite le conducteur électrique 23 est connecté à la carte électronique 22, par une brasure ou soudure par exemple.

Le procédé selon l'invention peut être associé à l'une quelconque des caractéristiques décrites précédemment en rapport avec le dispositif de connexion 10 ou l'ensemble selon l'invention.

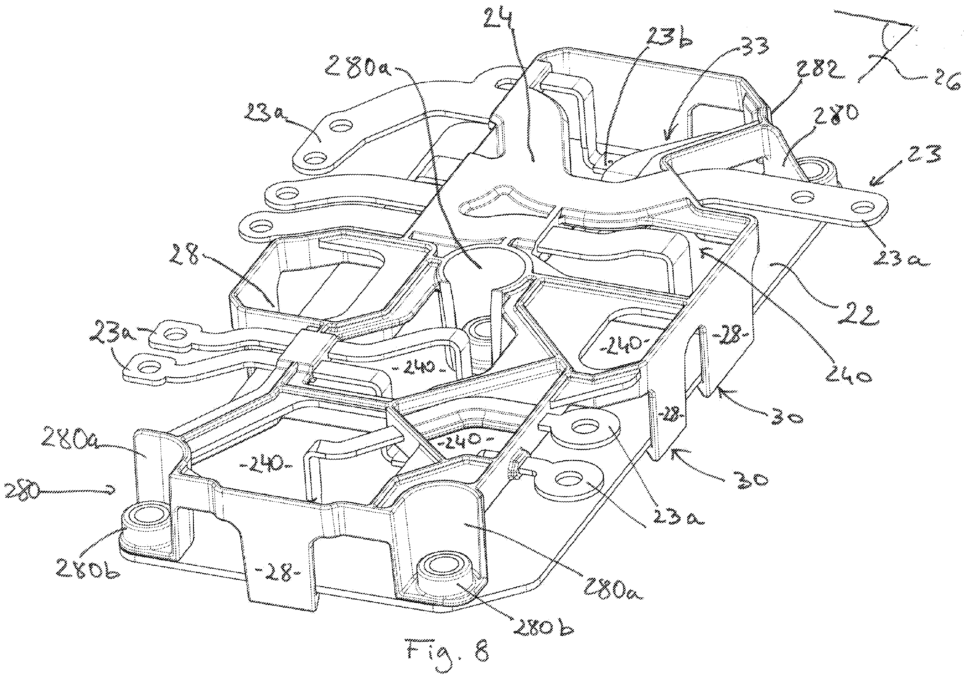

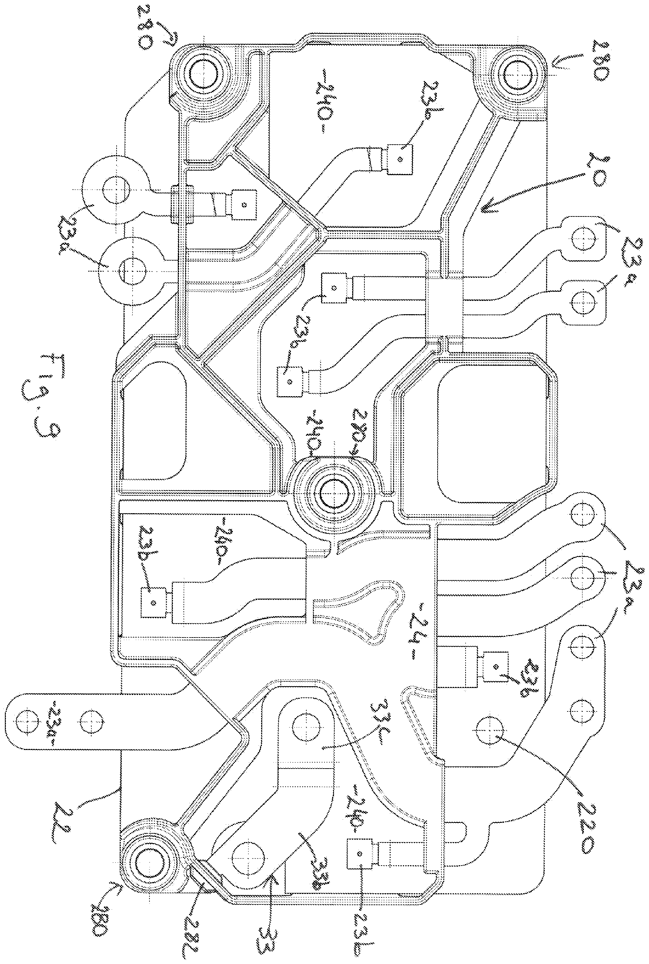

Les figures 8 et 9 présentent un autre mode de réalisation du dispositif 20 selon l'invention associé à une carte électronique 22. Dans ce mode de réalisation, le corps 24 a une surface pleine formant une paroi qui s'étend dans le plan 26. Grâce à sa forme de paroi, le dispositif 20 peut maintenir les conducteurs 23 sur une portion plus importante que dans l'exemple illustré en figure 3. Ainsi, le corps 24 améliore le maintien des conducteurs 23 dans leur acheminement au plus près des zones de la carte 22 sur lesquelles leurs deuxièmes extrémités 23b sont destinées à être mises en contact. Le corps 24 peut comprendre des nervures pour améliorer sa rigidité.

La paroi 24 peut comprendre des ouvertures 240. Lorsque le dispositif 20 est positionné en vis-à-vis de la carte électronique 22, ces ouvertures 240 permettent d'accéder aux deuxièmes extrémités 23b des conducteurs 23 afin d'assurer un contact électrique entre les conducteurs 23 et la carte 22. Les ouvertures 240 peuvent également permettre l'accès à des composants de la carte 22.

Dans ce mode de réalisation, le dispositif 20 comprend au moins une excroissance avec un organe d'assemblage 30 tel que décrits précédemment. Dans l'exemple particulier illustré aux figures 8 et 9, le dispositif 20 comporte plusieurs excroissances 28 et des organes d'assemblage 30 respectifs qui permettent de maintenir le corps 24 en vis-à-vis de la carte électronique 22, en particulier en venant en périphérie de la carte 22. Le corps 24 peut présenter des ouvertures dont les périphéries respectives comprennent la naissance d'une ou plusieurs excroissances 28 pour améliorer la souplesse de celles-ci lors du montage du dispositif 20 sur la carte 22, dans le cas d'un montage par clipsage par exemple.

Le dispositif 20 peut comprendre en outre des moyens configurés pour maintenir l'ensemble formé par le dispositif 20 et la carte électronique 22 sur une surface. Ainsi, lorsque les conducteurs 23 du dispositif 20 sont connectés électriquement à la carte 22, l'ensemble peut être positionné sur une surface. En particulier, les moyens du dispositif 20 permettent de plaquer la carte électronique 22 sur la surface, par exemple une surface de dissipation thermique. Ces moyens de plaquage permettent en outre de renforcer le maintien du dispositif 20 sur la carte 22 pendant la durée de vie de l'ensemble. Les moyens de plaquage peuvent comprendre une excroissance en forme de fut 280 s'étendant depuis le corps 24. En particulier, le moyen de plaquage comprend une portion 280a de paroi de fut et un fond 280b comprenant une ouverture destinée à recevoir un moyen de fixation avec la carte 22 et la surface. La carte 22 peut comprendre des moyens pour son seul plaquage sur la surface, par exemple un trou 220 qui reçoit une vis s'introduisant dans la surface de plaquage.

Dans l'exemple illustré en figures 3 et 4, les conducteurs électriques 23 sont maintenus par le corps 24 au niveau du plan 26. Cependant, le dispositif 20 selon l'invention peut comprendre au moins un conducteur 33 maintenu par une excroissance 282 s'étendant dans une direction transversale depuis le corps 24. En particulier, le conducteur 33 peut comprendre une première portion s'étendant dans l'excroissance 282 suivant une direction transversale au plan 26.

Dans l'exemple illustré en figures 8 et 9, le conducteur 33 permet une reprise de masse entre la carte électronique 22 et la surface sur laquelle l'ensemble est plaqué. En particulier, le conducteur 33 comprend une deuxième portion 33b destinée à être fixée sur un fut issu de la surface de plaquage et une troisième portion destinée à être mise en contact avec la carte électronique 22, en particulier avec une piste conductrice de la carte 22.

## Revendications

1. Dispositif de connexion électrique (20) d'une carte électronique (22) comprenant
au moins un conducteur électrique (23) pour conduire un courant vers et/ou depuis ladite carte électronique (22),
un corps (24) ayant une forme destinée à venir en correspondance avec la périphérie extérieure de la carte électronique, une portion dudit corps s'étendant au moins suivant un plan (26) et maintenant dans ce plan ledit conducteur électrique (23) au niveau d'une portion dudit conducteur comprise entre une première extrémité apte à être mise en contact avec un élément extérieur de la carte électronique et une seconde extrémité apte à être mise en contact avec ladite carte électronique, **caractérisé en ce qu'** au moins une excroissance (28) s'étendant depuis la périphérie dudit corps (24) suivant une direction transversale au plan (26), ladite excroissance (28) comprenant au moins un organe d'assemblage (30) du dispositif de connexion (20) avec ladite carte électronique (22), ledit au moins un organe d'assemblage (30) étant apte à coopérer avec un bord périphérique de la carte électronique (22) de sorte que la portion dudit corps (24) s'étendant selon le plan (26) vienne en vis-à-vis de la carte électronique (22), et
dans lequel ledit au moins un organe d'assemblage est configuré pour solidariser le dispositif de connexion et la carte électronique (22) au niveau d'une périphérie de la carte électronique (22).

2. Dispositif selon la revendication 1 dans lequel l'organe d'assemblage (30) comprend une première portion (30a) sensiblement plane naissant au niveau d'une extrémité distale de l'excroissance (28) et s'étendant vers l'extérieur du dispositif de connexion (20).

3. Dispositif selon la revendication précédente dans lequel ladite première portion (30a) comprend un trou traversant.

4. Dispositif selon la revendication 2 dans lequel l'organe d'assemblage (30) comprend une deuxième portion (30b) sensiblement plane transversale à la première portion (30a), la deuxième portion (30a) comprenant un trou.

5. Dispositif selon la revendication précédente dans lequel le trou est traversant.

6. Dispositif selon l'une des revendications précédentes dans lequel ladite excroissance (28) s'étend depuis ledit corps (24) suivant une direction transversale audit plan (26).

7. Dispositif selon la revendication 6 dans lequel le corps (24) a une forme sensiblement rectangulaire dans ledit plan (26).

8. Dispositif selon la revendication 6 dans lequel le corps (24) a une forme de paroi qui s'étend dans le plan 26.

9. Dispositif selon la revendication 8 dans lequel le corps (24) comprend au moins une ouverture (240) configurée pour permettre d'accéder à l'extrémité (23b) des conducteurs (23) qui est en contact avec la carte 22 lorsque le dispositif 20 est positionné sur la carte 22.

10. Dispositif selon l'une des revendications précédentes, dans lequel l'excroissance (28) s'étend depuis une périphérie du corps (24).

11. Dispositif selon l'une des revendications précédentes dans lequel le corps (24) et l'excroissance (28) sont d'un seul tenant.

12. Dispositif selon l'une des revendications précédentes, dans lequel ledit conducteur (23) comprend une première extrémité (23a) libre de la matière du corps (24) pour être mise en contact avec un élément extérieur à la carte (22) et une deuxième extrémité (23b) également libre de la matière du corps (24) pour être mise en contact avec la carte électronique (22), la deuxième extrémité (23b) étant située à une distance dudit plan (26) supérieure à la distance de l'extrémité distale de l'excroissance (28) de sorte que lorsque le dispositif de connexion (10) vient sur la carte électronique (22), les connecteurs (23) exercent une contrainte sur la surface de la carte.

13. Dispositif selon l'une des revendications précédentes, dans lequel l'excroissance (28) est une paroi continue s'étendant depuis toute la périphérie du corps (24).

14. Dispositif selon l'une des revendications 1 à 12 comportant une pluralité d'excroissances (28) et des organes d'assemblage (30) respectifs qui permettent de maintenir le corps (24) en vis-à-vis de la carte électronique (22).

15. Ensemble comprenant une première carte électronique (22) et un dispositif de connexion électrique (20) selon l'une des revendications précédentes dans lequel
le corps (24) du dispositif de connexion (20) a une première face venant en vis-à-vis de la première carte électronique (22), et
l'organe d'assemblage (30) solidarise ensemble la première carte électronique (22) et le dispositif de connexion (20).

16. Ensemble selon la revendication 15 dans lequel l'organe d'assemblage (30) solidarise le dispositif de connexion (20) et la première carte (22) au niveau d'une périphérie de la première carte (22).

17. Ensemble selon la revendication 15 ou 16, le dispositif (20) étant selon l'une des revendications 3 à 5 dans lequel la première carte électronique (22) comprend un ergot (21) venant en prise dans le trou de l'organe d'assemblage (30).

18. Ensemble selon la revendication 17 dans lequel ledit ergot (21) est situé sur un bord périphérique de la première carte électronique (22).

19. Ensemble selon l'une des revendications 15 à 18 comprenant en outre une deuxième carte électronique montée en vis-à-vis d'une deuxième face du corps (24), ladite deuxième face étant opposée à la première face.

20. Ensemble selon l'une des revendications 15 à 19, étant en outre configuré pour être plaqué sur une surface, ensemble dans lequel le dispositif (20) comprend un conducteur (33) configuré pour permettre une reprise de masse entre la carte électronique (22) et ladite surface.

21. Procédé de connexion électrique d'une carte électronique (22) comprenant des étapes consistant à :
- assembler le dispositif (20) selon l'une quelconque des revendications 1 à 13 avec la carte électronique (22) par l'intermédiaire de l'organe d'assemblage (30),
- connecter le conducteur électrique (23) dudit dispositif de connexion (20) à la carte électronique (22).

22. Procédé selon la revendication précédente dans lequel le conducteur électrique (23) est connecté par brasure.

## Patentansprüche

1. Elektrische Verbindungsvorrichtung (20) einer Elektronikplatine (22), umfassend:
mindestens einen elektrischen Leiter (23), um einen Strom zu der und/oder von der Elektronikplatine (22) zu leiten,
einen Körper (24) mit einer Form, die bestimmt ist, mit dem äußeren Umfang der Elektronikplatine in Übereinstimmung zu kommen, wobei sich ein Abschnitt des Körpers mindestens gemäß einer Ebene (26) erstreckt und in dieser Ebene den elektrischen Leiter (23) im Bereich eines Abschnitts des Leiters hält, der zwischen einem ersten Ende, das imstande ist, mit einem äußeren Element der Elektronikplatine in Kontakt versetzt zu sein, und einem zweiten Ende, das imstande ist, mit der Elektronikplatine in Kontakt versetzt zu sein, inbegriffen ist,
**dadurch gekennzeichnet, dass**
sich mindestens eine Ausstülpung (28) ab dem Umfang des Körpers (24) gemäß einer zu der Ebene (26) transversalen Richtung erstreckt, wobei die Ausstülpung (28) mindestens ein Verbindungsorgan (30) der Verbindungsvorrichtung (20) mit der Elektronikplatine (22) umfasst, wobei das mindestens eine Verbindungsorgan (30) imstande ist, mit einem Umfangsrand der Elektronikplatine (22) derart zusammenzuwirken, dass der Abschnitt des Körpers (24), der sich gemäß der Ebene (26) erstreckt, gegenüber der Elektronikplatine (22) kommt, und
wobei das mindestens eine Verbindungsorgan konfiguriert ist, um die Verbindungsvorrichtung und die Elektronikplatine (22) im Bereich eines Umfangs der Elektronikplatine (22) fest zu verbinden.

2. Vorrichtung nach Anspruch 1, wobei das Verbindungsorgan (30) einen ersten, etwa ebenen Abschnitt (30a) umfasst, der im Bereich eines distalen Endes der Ausstülpung (28) entsteht und sich nach außerhalb der Verbindungsvorrichtung (20) erstreckt.

3. Vorrichtung nach vorangehendem Anspruch, wobei der erste Abschnitt (30a) ein durchgehendes Loch umfasst.

4. Vorrichtung nach Anspruch 2, wobei das Verbindungsorgan (30) einen zweiten, etwa ebenen Abschnitt (30b) umfasst, der zu dem ersten Abschnitt (30a) etwa quer ist, wobei der zweite Abschnitt (30a) ein Loch umfasst.

5. Vorrichtung nach vorangehendem Anspruch, wobei das Loch durchgehend ist.

6. Vorrichtung nach einem der vorangehenden Ansprüche, wobei sich die Ausstülpung (28) ab dem Körper (24) gemäß einer zu der Ebene (26) transversalen Richtung erstreckt.

7. Vorrichtung nach Anspruch 6, wobei der Körper (24) eine in der Ebene (26) etwa rechteckige Form hat.

8. Vorrichtung nach Anspruch 6, wobei der Körper (24) eine Wandform hat, die sich in der Ebene (26) erstreckt.

9. Vorrichtung nach Anspruch 8, wobei der Körper (24) mindestens eine Öffnung (240) umfasst, die konfiguriert ist, um den Zugang zu dem Ende (23b) der Leiter (23) zu erlauben, das mit der Platine (22) im Kontakt ist, wenn die Vorrichtung (20) auf der Platine (22) positioniert ist.

10. Vorrichtung nach einem der vorangehenden Ansprüche, wobei sich die Ausstülpung (28) ab einem Umfang des Körpers (24) erstreckt.

11. Vorrichtung nach einem der vorangehenden Ansprüche, wobei der Körper (24) und die Ausstülpung (28) einstückig sind.

12. Vorrichtung nach einem der vorangehenden Ansprüche, wobei der Leiter (23) ein erstes Ende (23a), das frei von der Materie des Körpers (24) ist, um mit einem Element außerhalb der Platine (22) in Kontakt versetzt zu sein, und ein zweites Ende (23b), das ebenfalls frei von der Materie des Körpers (24) ist, um mit der Elektronikplatine (22) in Kontakt versetzt zu sein, umfasst, wobei sich das zweite Ende (23b) in einem Abstand von der Ebene (26) befindet, der größer als der Abstand des distalen Endes der Ausstülpung (28) ist, so dass, wenn die Verbindungsvorrichtung (10) auf die Elektronikplatine (22) gelangt, die Verbinder (23) auf die Oberfläche der Karte eine Beanspruchung ausüben.

13. Vorrichtung nach einem der vorangehenden Ansprüche, wobei die Ausstülpung (28) eine kontinuierliche Wand ist, die sich ab dem gesamten Umfang des Körpers (24) erstreckt.

14. Vorrichtung nach einem der Ansprüche 1 bis 12, aufweisend eine Vielzahl von Ausstülpungen (28) und jeweiliger Verbindungsorgane (30), die erlauben, den Körper (24) gegenüber der Elektronikplatine (22) zu halten.

15. Einheit, umfassend eine erste Elektronikplatine (22) und eine elektrische Verbindungsvorrichtung (20) nach einem der vorangehenden Ansprüche, wobei
der Körper (24) der Verbindungsvorrichtung (20) eine erste Fläche hat, die gegenüber der ersten Elektronikplatine (22) kommt, und
das Verbindungsorgan (30) die erste Elektronikplatine (22) und die Verbindungsvorrichtung (20) fest miteinander verbindet.

16. Einheit nach Anspruch 15, wobei das Verbindungsorgan (30) die Verbindungsvorrichtung (20) und die erste Platine (22) im Bereich eines Umfangs der ersten Platine (22) fest verbindet.

17. Einheit nach Anspruch 15 oder 16, wobei die Vorrichtung (20) nach einem der Ansprüche 3 bis 5 ist, wobei die erste Elektronikplatine (22) einen Sporn (21) umfasst, der im Loch des Verbindungsorgans (30) in Eingriff kommt.

18. Einheit nach Anspruch 17, wobei sich der Sporn (21) auf einem Umfangsrand der ersten Elektronikplatine (22) befindet.

19. Einheit nach einem der Ansprüche 15 bis 18, umfassend ferner eine zweite Elektronikplatine, die gegenüber einer zweiten Fläche des Körpers (24) angebracht ist, wobei die zweite Fläche gegenüber der ersten Fläche ist.

20. Einheit nach einem der Ansprüche 15 bis 19, die ferner konfiguriert ist, um auf einer Oberfläche aufgelegt zu sein, wobei die Vorrichtung (20) der Einheit einen Leiter (33) umfasst, der konfiguriert ist, um einen Massenschluss zwischen der Elektronikplatine (22) und der Oberfläche zu erlauben.

21. Verfahren zur elektrischen Verbindung einer Elektronikplatine (22), umfassend die Schritte, die darin bestehen:
- Anschließen der Vorrichtung (20) nach einem der Ansprüche 1 bis 13 an die Elektronikplatine (22) mittels des Verbindungsorgans (30),
- Verbinden des elektrischen Leiters (23) der Verbindungsvorrichtung (20) mit der Elektronikplatine (22).

22. Verfahren nach vorangehendem Anspruch, wobei der elektrische Leiter (23) durch Löten verbunden wird.

## Claims

1. Electrical connection device (20) of an electronic board (22) comprising
at least one electrical conductor (23) for conducting a current to and/or from said electronic board (22),
a body (24) with a shape designed to fit with the outer periphery of the electronic board, a portion of said body extending at least following one plane (26) and retaining said electrical conductor (23) in said plane via a portion of said conductor included between a first end designed to come into contact with an external element of the electronic board, and a second end designed to come into contact with said electronic board,
**characterised in that**
at least one outgrowth (28) extending from the periphery of said body (24) following a direction transversal to the plane (26), whereby said outgrowth (28) includes at least one member (30) for assembling said connection device (20) to said electronic board (22), whereby said assembly member (30) can cooperate with a peripheral edge of the electronic board (22) so that the portion of said body (24) extending along the plane (26) is opposite the electronic board (22), and
in which said at least one assembly member is configured to secure the connection device and the electronic board (22) at the periphery of the electronic board (22).

2. Device according to claim 1, in which the assembly member (30) comprises a first portion (30a) that is largely flat and begins at the distal end of the outgrowth (28) and extends towards the exterior of the connection device (20).

3. Device according to the previous claim in which said first portion (30a) comprises a through-hole.

4. Device according to claim 2, in which the assembly member (30) comprises a second portion (30b) that is largely flat and arranged transversally with respect to the first portion (30a), and where the second portion (30a) features a hole.

5. Device according to the previous claim in which the hole is a through-hole.

6. Device according to one of the previous claims, in which said outgrowth (28) extends from said body (24) following a transversal direction with respect to said plane (26).

7. Device according to claim 6 in which the body (24) features a largely rectangular shape in said plane (26).

8. Device according to claim 6 in which the body (24) features the shape of a wall that extends into the plane 26.

9. Device according to claim 8 in which the body (24) features at least one opening (240) configured to provide access to the end (23b) of the conductors (23), whereby said end is in contact with the board 22 when the device 20 is positioned on the board 22.

10. Device according to one of the previous claims, in which said outgrowth (28) extends from the periphery of the body (24).

11. Device according to one of the previous claims in which the body (24) and the outgrowth (28) are made of a single part.

12. Device according to one of the previous claims, in which said conductor (23) includes a first end (23a) that is free of material from the body (24) and comes into contact with an external element of the board (22) and a second end (23b) that is also free of material from the body (24) and comes into contact with the electronic board (22), whereby the second end (23b) is located at a distance from said plane (26) that is greater than the distance from the distal end of the outgrowth (28), so that when the connection device (10) comes into contact with the electronic board (22), the connectors (23) exert some constraint on the surface of the board.

13. Device according to one of the previous claims, in which said outgrowth (28) is an uninterrupted wall that extends from the entire periphery of the body (24).

14. Device according to one of the claims 1 to 12, in which said device features a plurality of outgrowths (28) and respective assembly members (30) that hold the body (24) in position with respect to the electronic board (22).

15. Unit that includes a first electronic board (22) and an electrical connection device (20) according to one of the previous claims, in which
the body (24) of the connection device (20) features a first face that is located opposite the first electronic board (22), and
the assembly member (30) secures the first electronic board (22) to the connection device (20).

16. Unit according to claim 15 in which the assembly member (30) secures the connection device (20) to the first board (22) at the periphery of the first board (22).

17. Unit according to claim 15 or 16, whereby the device (20) follows one of the claims 3 to 5, in which the first electronic board (22) features a lug (21) that is secured inside the hole of the assembly member (30).

18. Unit according to claim 17 in which said lug (21) is located on the periphery of the first electronic board (22).

19. Unit according to one of the claims 15 to 18, also including a second electronic board mounted opposite a second face of the body (24), whereby the second face is opposite the first face.

20. Unit according to one of the claims 15 to 19, also configured to bear against a surface, whereby said unit features the device (20) that includes a conductor (33) configured to use the grounding connection between the electronic board (22) and said surface.

21. Electrical connection process of an electronic board (22) that includes the following steps:
- assembling the device (20) to the electronic board (22) using the assembly member (30), according to any of the claims 1 to 13,
- connecting the electrical conductor (23) of said connection device (20) to the electronic board (22).

22. Process according to the previous claim in which the electrical conductor (23) is connected by brazing.
